(19) Europäisches Patentamt / European Patent Office / Office européen des brevets

(11) **EP 2 541 770 B1**

(12) **FASCICULE DE BREVET EUROPEEN**

(45) Date de publication et mention
de la délivrance du brevet:
**23.04.2014 Bulletin 2014/17**

(51) Int Cl.:
*H03K 5/13* *(2014.01)*     *H01L 45/00* *(2006.01)*

(21) Numéro de dépôt: **12173611.0**

(22) Date de dépôt: **26.06.2012**

(54) **Générateur de retards utilisant une résistance programmable à base de matériau à changement de phase**

Verzögerungsgenerator, der einen programmierbaren Widerstand aus Phasenwechselmaterial benutzt

Delay generator using a programmable resistance made of phase-change material

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **27.06.2011 FR 1155698**

(43) Date de publication de la demande:
**02.01.2013 Bulletin 2013/01**

(73) Titulaire: **COMMISSARIAT A L'ENERGIE
ATOMIQUE ET AUX
ENERGIES ALTERNATIVES
75015 Paris (FR)**

(72) Inventeurs:
• **Suri, Manan**
  **38000 Grenoble (FR)**
• **De Salvo, Barbara**
  **38330 Montbonnot Saint Martin (FR)**

(74) Mandataire: **Brunelli, Gérald
Marks & Clerk France
Immeuble Visium
22, avenue Aristide Briand
94117 Arcueil Cedex (FR)**

(56) Documents cités:
**WO-A1-2011/074021     JP-A- 63 312 715**

• **IELMINI D ET AL: "Reliability Impact of
Chalcogenide-Structure Relaxation in Phase-
Change Memory (PCM) Cells - Part I:
Experimental Study", IEEE TRANSACTIONS ON
ELECTRON DEVICES, IEEE SERVICE CENTER,
PISACATAWAY, NJ, US, vol. 56, no. 5, 1 mai 2009
(2009-05-01), pages 1070-1077, XP011254208,
ISSN: 0018-9383**

**Description**

L'invention concerne un générateur de retards utilisant une résistance programmable à base de matériau à changement de phase. Elle s'applique notamment au domaine des dispositifs électroniques de génération de délais.

Le besoin de générer des délais temporels précis est requis dans de nombreuses applications électroniques. Pour cela, des circuits de génération de délais à base de condensateurs sont habituellement utilisés. Des exemples de tels circuits sont décrits dans l'article de W. F. Davis et T. M. Frederiksen intitulé a precision monolithic time-delay generator for use in automotive electronic fuel injection systems, IEEE journal on solid state circuits, Vol. 7, No. 6, décembre 1972.

JP 63 312715 A divulgue un générateur de retards comprenant un condensateur et un comparateur comparant une quantité électrique de référence $V_1$ stable dans le temps avec une quantité électrique variable $V_2$ représentative de la charge au condensateur, le comparateur générant un signal $\Phi_2$ présentant une singularité, ladite singularité apparaissant lorsque la différence entre les deux quantités électriques change de signe.

Un des inconvénients de ce type de circuits est la place qu'ils prennent, notamment lorsqu'ils sont mis en oeuvre dans un circuit intégré. Un autre inconvénient est qu'ils ne peuvent pas générer de délais sur des plages de valeurs importantes, par exemple sur une plage allant d'une milliseconde à plusieurs centaines de minutes. En outre, en utilisant un générateur de retards à base de condensateurs, il est difficile de générer avec précision des délais importants, de l'ordre d'une centaine de secondes par exemple.

Un but de l'invention est notamment de pallier les inconvénients précités.

A cet effet l'invention a pour objet un générateur de retards comprenant au moins une résistance programmable $R_{PCM}$ en matériau à changement de phase à base de chalcogénure. Ladite résistance $R_{PCM}$ est initialisée pour générer un retard de manière à ce qu'elle soit égale à une valeur initiale $R_0$ et que le chalcogénure soit en phase amorphe. Un comparateur compare une quantité électrique de référence stable dans le temps avec une quantité électrique variable représentative de la résistance programmable $R_{PCM}$, le comparateur générant un signal s présentant une singularité, ladite singularité apparaissant lorsque la différence entre les deux quantités électriques change de signe.

Selon un aspect de l'invention, la quantité électrique de référence est représentative d'une résistance de référence $R_{reference}$.

Un module de programmation initialise par exemple la résistance $R_{PCM}$ par émission d'une impulsion électrique, ladite impulsion étant adaptée pour que la résistance $R_{PCM}$ atteigne la valeur initiale $R_0$.

Dans un mode de réalisation, les caractéristiques de l'impulsion électrique pour programmer la résistance $R_{PCM}$ sont déterminées en utilisant une table de correspondance.

Selon un autre aspect de l'invention, le signal s peut prendre deux états, la singularité correspondant au passage d'un état à l'autre.

Le comparateur est par exemple un comparateur de courants et la quantité électrique variable et la quantité électrique de référence sont des intensités.

De manière alternative, le comparateur peut être un comparateur de tensions et la quantité électrique variable et la quantité électrique de référence des tensions.

Dans un mode de réalisation, la valeur de $R_0$ permettant d'obtenir un retard donné T, est déterminée en utilisant l'expression :

$$R_0 = R_{reference} \times \left( \frac{t_0}{T} \right)^{\nu}$$

dans laquelle :

$R$ est la résistance du matériau PCM à l'instant t ;
$R_0$ est la résistance du matériau PCM à un instant initial $t_0$ ;
$\nu$ est une constante dépendant du type de matériau chalcogénure utilisé.

Selon un aspect de l'invention, le chalcogénure utilisé est un mélange de germanium, d'antimoine et de tellure.

Selon un autre aspect de l'invention, le chalcogénure utilisé est du Ge2Sb2Te5.

L'invention a aussi pour objet un système un système d'inhibition de neurones artificiels comprenant un circuit de neurones, le temps à partir duquel la sortie du circuit de neurones est apparente étant contrôlé par un générateur de retards tel que décrit précédemment.

L'invention a notamment comme avantage que la fabrication de circuits supplémentaires dédiés à la génération de retards n'est pas nécessaire dans des systèmes comprenant déjà des matériaux à changement de phase.

D'autres caractéristiques et avantages de l'invention apparaîtront à l'aide de la description qui suit donnée à titre illustratif et non limitatif, faite en regard des dessins annexés parmi lesquels :

- la figure 1 donne un exemple de résistance programmable à base de matériau à changement de phase ;
- la figure 2 présente un ensemble de courbes illustrant les variations de résistance d'un matériau à changement de phase pour différentes durées d'impulsions ;
- la figure 3 illustre de manière simplifiée le principe de génération de retards selon l'invention ;
- la figure 4 présente un mode de réalisation de l'invention utilisant un comparateur de courants ;
- la figure 5 présente un mode de réalisation de générateur de retards utilisant un comparateur de tensions ;
- la figure 6 donne un exemple de système de programmation d'un modèle de pics de neurones.

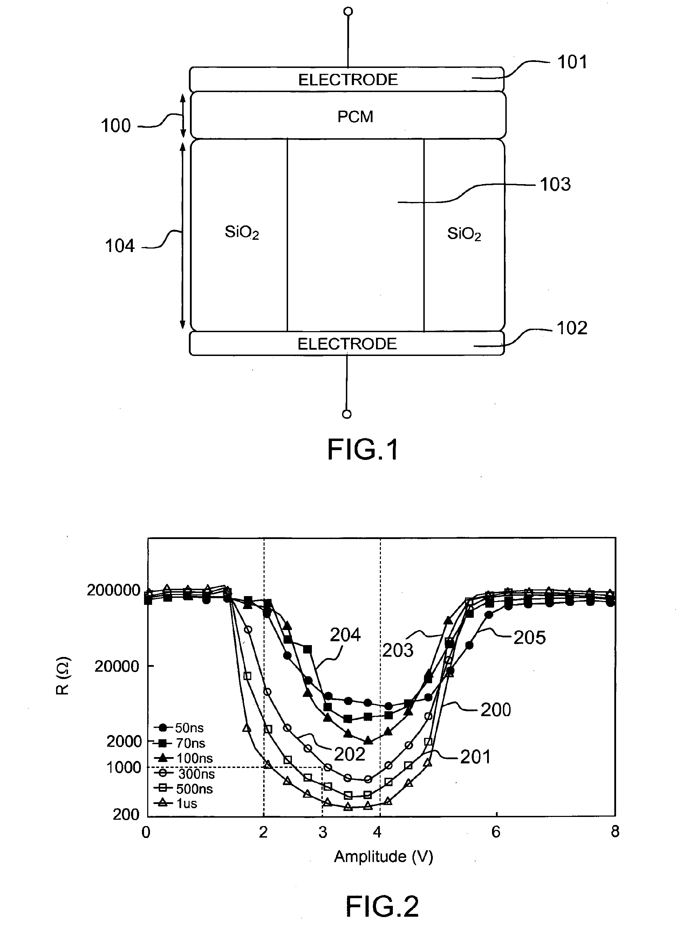

La figure 1 donne un exemple de résistance programmable à base de matériau à changement de phase. Les matériaux à changement de phase sont utilisés fréquemment en électronique. Ils sont habituellement désignés par l'acronyme PCM venant de l'expression anglo-saxonne « Phase Change Memory ». Les matériaux PCM sont composés de chalcogénure. Ils sont notamment utilisés au sein de supports optiques de stockage comme les disques compacts CD, les disques numériques polyvalents désignés par l'acronyme DVD venant de l'expression anglo-saxonne « Digital Versatile Disc » et les disques Blu-ray. Les matériaux PCM sont également utilisés pour le développement à grande échelle de mémoires électroniques non volatiles dites mémoires PRAM, acronyme venant de l'expression anglo-saxonne « Phase-change Random Access Memory ».

Les dispositifs mettant en oeuvre des matériaux PCM fonctionnent sur le principe de la commutation réversible entre les deux états du chalcogénure. La commutation est induite par effet Joule. Le premier état du matériau chalcogénure est désigné habituellement par l'expression « phase amorphe » et le second état par l'expression « phase cristalline ». Une propriété importante des chalcogénures est que leur résistance électrique est plus élevée en phase amorphe qu'en phase cristalline.

Les dispositifs à base de matériau PCM sont habituellement composés d'au moins une résistance programmable. L'exemple de résistance programmable présenté à l'aide de la figure 1 est constitué d'une fine couche de matériau chalcogénure 100 de 100 nm d'épaisseur et d'une couche intermédiaire 104 de 400 nm d'épaisseur, ces deux couches étant placées entre deux électrodes métalliques 101, 102. A titre d'exemple, le chalcogénure utilisé dans cette résistance programmable peut être un mélange de germanium, d'antimoine et de tellure, comme par exemple du Ge2Te2Sb5.

La couche intermédiaire 104 est composée d'une fiche cylindrique 103 en tungstène de 300 nm de diamètre, ladite fiche étant entourée d'oxyde de silicium Si02. De nombreuses architectures de résistances programmables à base de chalcogénure existent dans l'état de la technique et peuvent être utilisées dans le cadre de l'invention.

Quand une différence de potentiel est appliquée entre les deux électrodes métalliques de la résistance programmable, le courant circule au travers de la fiche cylindrique 103 en tungstène ainsi qu'au travers de la couche de matériau PCM 100. Cette circulation de courant implique que la température du matériau PCM augmente par effet Joule.

Pour faire passer le matériau PCM de la phase cristalline à la phase amorphe, une forte impulsion de courant d'une durée de quelques dizaines de nanosecondes par exemple permet de chauffer le matériau PCM de manière à ce que celui-ci atteigne sa température de fusion. Le courant est ensuite coupé rapidement, c'est-à-dire en quelques nanosecondes. Cela permet de fixer le chalcogénure en phase amorphe.

A titre d'exemple, pour faire passer le matériau PCM de la phase amorphe à la phase cristalline, une impulsion de courant de plus faible amplitude est appliquée de manière à ce que la température du matériau PCM dépasse sa température de cristallisation sans pour autant dépasser sa température de fusion. Le matériau est maintenu à cette température pendant une durée suffisante afin que la matière soit parfaitement cristallisée. En considérant l'exemple de la figure 1, une impulsion d'une durée comprise entre 50 et 150 ns permet une cristallisation complète du matériau PCM de la résistance programmable. Il est à noter que la durée optimum de l'impulsion dépend du matériau PCM choisi.

La figure 2 présente un ensemble de courbes illustrant les variations de résistance d'un matériau PCM pour différentes durées d'impulsions électriques, et ce en fonction de l'amplitude des impulsions électriques utilisées. Dans cet exemple, le matériau PCM est initialement en phase amorphe. Six courbes sont représentées. La première courbe 200 correspond à une durée d'impulsion électrique de 1 µs, la seconde 201 à une durée d'impulsion de 500 ns, la troisième 202 à une durée d'impulsion de 300 ns, la quatrième 203 à une durée d'impulsion de 100 ns, la cinquième 204 à une durée d'impulsion de 70 ns et la sixième 205 à une durée d'impulsion de 50 ns.

Il apparaît que le matériau PCM peut être cristallisé de manière à ce qu'une résistance de quelques centaines d'ohms soit obtenue. Pour cela, des impulsions dont la tension est comprise entre 2 et 4 volts peuvent être utilisées. Afin d'obtenir une résistance plus importante en phase amorphe, une impulsion de tension supérieure à 4 volts peut être utilisée. Ces valeurs sont données à titre d'exemple et seront différentes en fonction de l'architecture et des matériaux utilisés au sein de la résistance programmable.

Une propriété importante propre aux matériaux PCM est que dans la phase amorphe, la résistance dérive dans le temps. Cette dérive est la conséquence de relaxations structurelles des zones du chalcogénure étant en phase amorphe. Cette dérive est par contre négligeable lorsque le matériau est en phase cristalline. Il est à noter que la dérive de résistance en phase amorphe augmente avec le temps. Cette dérive de la résistance est déterministe et peut s'exprimer en utilisant l'expression suivante :

$$R = R_0 \times \left( t/t_0 \right)^{\nu} \qquad (1)$$

dans laquelle :

$R$ est la résistance du matériau PCM à l'instant t ;

$R_0$ est la résistance du matériau PCM à un instant initial $t_0$, par exemple l'instant de la programmation de ladite résistance ;

$\nu$ est un paramètre dépendant du type de matériau chalcogénure utilisé ; à titre d'exemple, si du Ge2Te2Sb5 est utilisé, la valeur de $\nu$ est comprise entre 0.11 à 0.13.

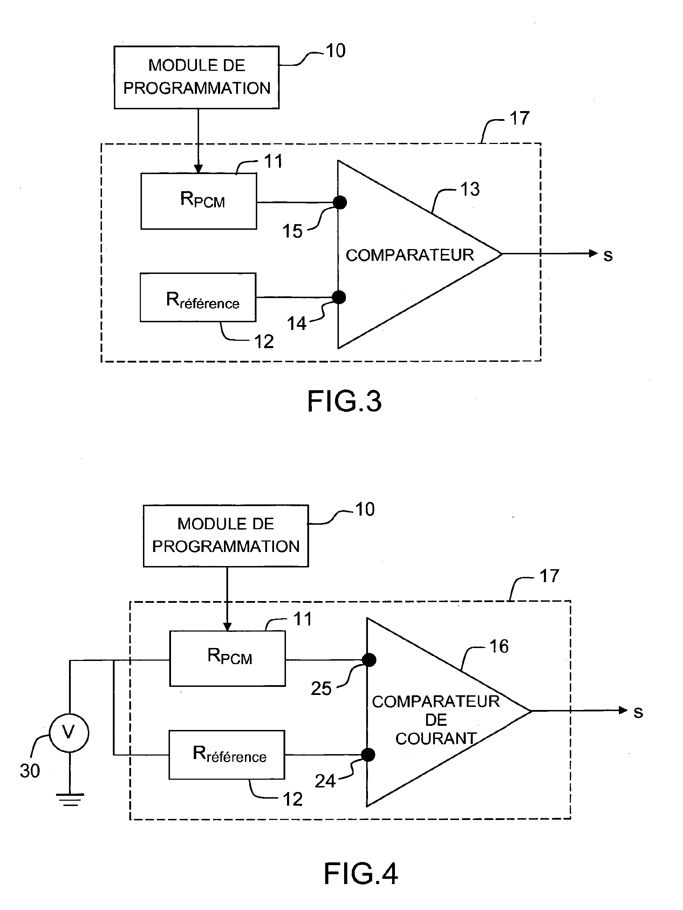

La figure 3 illustre de manière simplifiée le principe de génération de retards selon l'invention. Celui-ci exploite la propriété de la dérive de résistance des matériaux PCM en phase amorphe. Le générateur de retard comprend au moins, une résistance programmable 11 en matériau PCM, une résistance de référence 12 et un comparateur 13 de quantités électriques. Ces différents éléments sont détaillés dans la suite de la description.

La résistance de référence $R_{reference}$ 12 est liée à l'une des bornes d'entrée 14 du comparateur 13. La valeur de la résistance de référence $R_{reference}$ est soit fixe soit programmable en fonction de la précision requise et de l'application visée.

La résistance programmable $R_{PCM}$ est composée de chalcogénure.

Afin de sélectionner une valeur initiale $R_0$ pour la résistance $R_{PCM}$, un module de programmation 10 peut être utilisé. La résistance est programmée par application d'une impulsion électrique adaptée. Les caractéristiques de l'impulsion électrique pour programmer la résistance $R_{PCM}$ peuvent être déterminées en utilisant une table de valeurs. Cette table de valeurs est par exemple représentative de courbes de caractéristique électrique du même type de celles présentées figure 2. La table de correspondance permettant de déterminer les caractéristiques des impulsions à générer varie en fonction du matériau chalcogénure utilisé.

Le module de programmation 10 est mis en oeuvre en utilisant par exemple un générateur d'impulsions électriques externe au générateur de retard. De manière alternative, le module de programmation peut-être inclus dans le générateur de retard. A titre d'exemple, un générateur d'impulsions peut être intégré sur une puce électronique. Il existe plusieurs techniques bien connues de l'homme du métier permettant de générer des impulsions électriques. Le choix de la technique de génération d'impulsion électrique dépend par exemple des exigences des applications pour lesquelles le générateur de retard est utilisé ainsi que de la précision que l'on veut obtenir.

Le comparateur 13 compris dans le générateur de retard a pour objectif de comparer les quantités électriques présentées à ses entrées 14, 15. Dans l'exemple de la figure 3, les quantités électriques présentées au niveau de la première 14 et de la seconde 15 entrée du comparateur 13 sont représentatives respectivement de la résistance de référence $R_{reference}$ 12 et de la résistance programmable $R_{PCM}$ 11. Ces quantités électriques sont par exemple des intensités ou des tensions.

Le comparateur 13 produit un signal de sortie s . A titre d'exemple, ce signal de sortie peut prendre deux états, un état BAS et un état HAUT ou bien deux valeurs, 0 et 1.

Le changement d'état du signal $s$ intervient un temps T suivant l'initialisation de la résistance $R_{PCM}$, ledit temps T correspondant à la valeur du retard que l'on veut générer.

De nombreuses implémentations permettant de comparer des quantités électriques représentatives des résistances $R_{PCM}$ et $R_{reference}$ existent dans l'état de la technique. Ces quantités électriques représentatives des résistances $R_{PCM}$ et $R_{reference}$ sont par exemple des tensions ou des courants. Ainsi, le comparateur 13 peut être un comparateur de tensions ou de courants par exemple.

Ainsi, afin de générer un retard de durée T, on choisit une valeur initiale $R_0$ et la résistance $R_{PCM}$ est programmée de manière à ce qu'elle prenne cette valeur initiale. Il est alors essentiel que le matériau chalcogénure soit en phase amorphe afin que le phénomène de dérive de la résistance puisse avoir lieu.

Pour déterminer la valeur de $R_0$, l'expression suivante dérivée directement de l'expression (1) peut être utilisée :

$$R_0 = R_{reference} \times \left( {t_0}/{T} \right)^{\nu} \qquad\qquad (2)$$

Il est à noter que le choix du type de chalcogénure utilisé pour la mise en oeuvre de la résistance $R_{PCM}$ détermine la valeur du paramètre $\nu$.

La quantité électrique présentée au niveau de la deuxième entrée 15 du comparateur 13 est représentative de la valeur de la résistance $R_{PCM}$ et est donc variable dans le temps.

L'initialisation du générateur de retards correspond à la programmation de la valeur initiale de la résistance programmable. Suite à l'initialisation du générateur, la résistance $R_{PCM}$ va commencer à dériver car elle comprend du matériau chalcogénure en phase amorphe.

La convention suivante peut alors être utilisée. Lorsque la quantité électrique variable représentative de la résistance programmable $R_{PCM}$ est inférieure à la quantité électrique de référence, le module de comparaison va générer un signal de sortie s dans un premier état. Lorsque la quantité électrique représentative de la résistance programmable est supérieure à la quantité électrique de référence, le signal s sera dans son deuxième état. Ainsi, lorsque la différence entre les deux quantités électriques change de signe, une transition entre les premiers et le deuxième état du signal s apparaît. Cette transition correspond à une singularité du signal s permettant de repérer le retard T généré.

Avantageusement, la flexibilité de programmation de la résistance $R_{PCM}$ permet de générer des délais sur des plages de valeurs très étendues, par exemple d'une milliseconde à plusieurs centaines de minutes.

La figure 4 présente un mode de réalisation de l'invention utilisant un comparateur de courants. Le courant présent introduit par la première entrée 24 du comparateur de courant 16 est comparé avec le courant introduit par la seconde entrée 25 du comparateur.

Dans cet exemple, la résistance de référence 12 est connectée à la première entrée 24 ainsi qu'à un générateur de tension 30. La résistance programmable 11 est connectée à la seconde entrée 25 ainsi qu'au générateur de tension 30. Les courants présents à la première 24 et à la seconde 25 entrées du comparateur de courant 16 sont des quantités électriques qui dépendent respectivement des résistances $R_{reference}$ 12 et $R_{PCM}$ 11. La résistance $R_{reference}$ étant stable dans le temps, le courant au niveau de la première entrée 24 est utilisé comme quantité électrique de référence. Plus la résistance $R_{PCM}$ augmente, plus l'intensité du courant au niveau de la seconde entrée 25 du comparateur 16 diminue.

Lorsque l'intensité du courant au niveau de la première entrée 24 du comparateur 16 est supérieure à la l'intensité du courant au niveau de la seconde entrée 25 du comparateur, le signal de sortie s du comparateur est dans un premier état.

Lorsque l'intensité du courant au niveau de la première entrée 24 du comparateur 16 est inférieure à la l'intensité du courant au niveau de la seconde entrée 25 du comparateur, le signal de sortie s du comparateur est dans un second état.

La transition entre les deux états du signal s intervient alors T secondes après l'initialisation de la résistance $R_{PCM}$. Le changement d'état du signal s correspond à une singularité permettant de repérer le temps T.

Plus généralement, dans le cadre de l'invention, tout signal s faisant intervenir une singularité au moment où le signe de la différence entre la quantité électrique de référence et la quantité électrique variable change peut être utilisée. Cette singularité peut être par exemple un pic ou une portion de signal dont les caractéristiques sont prédéterminées.

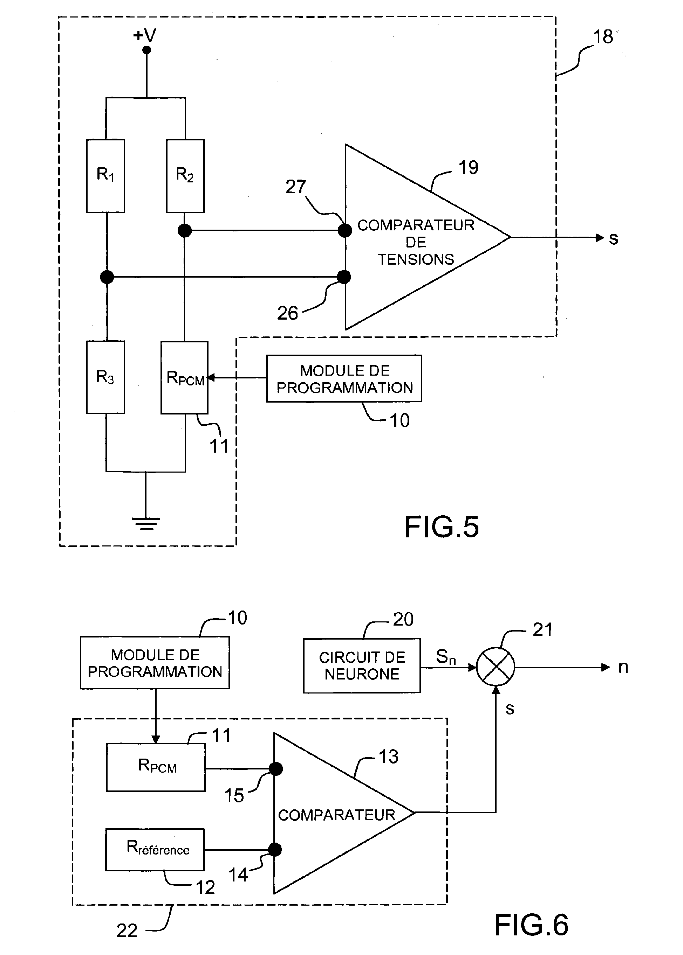

La figure 5 présente un mode de réalisation de générateur de retards utilisant un comparateur de tensions. La tension à la première borne 26 du comparateur de tensions 19 est comparée avec la tension à la seconde borne 27 dudit comparateur 19. Dans ce mode de réalisation, une tension de polarisation V est appliquée sur un montage de résistances. Ce montage est réalisé en utilisant deux jeux de deux résistances montées en série, les deux jeux de deux résistances étant ensuite montés en parallèle de manière à ce que la tension V puisse être appliquée à chacun d'eux. Le premier jeu de résistances montées en série comprend deux résistances R1 et R3 et le deuxième jeu de résistances montées en série comprend une résistance R2 et une résistance programmable $R_{PCM}$ 11 en matériaux chalcogénure. La première entrée 26 du comparateur de tension 19 prélève une première tension V1 entre les résistances R1 et R3 du premier jeu de résistances et la seconde entrée 27 prélève une seconde tension V2 entre les résistances R2 et $R_{PCM}$ du second jeu de résistances. Les tensions V1 et V2 peuvent être exprimées de la manière suivante :

$$V1 = \frac{V}{\left(1 + \dfrac{R1}{R3}\right)}$$

$$V2 = \frac{V}{\left(1 + \dfrac{R2}{R_{PCM}}\right)}$$

Les résistances R1, R2 et R3 ont des valeurs constantes dans le temps. Ainsi, la tension V1 est constante et joue le rôle de quantité électrique de référence. Quant à la résistance $R_{PCM}$, celle-ci est sujette au phénomène déterministe de dérive de résistance lorsque le chalcogénure est dans sa phase amorphe. La tension V2 varie dans le temps suivant une loi déterministe. La programmation de la valeur initiale $R_0$ de $R_{PCM}$ permet de choisir une valeur de retard T à générer. Un module de programmation 10 interne ou externe au générateur peut être utilisé pour sélectionner cette valeur initiale. Les valeurs des résistances R1, R2 et R3 peuvent être choisies en fonction de l'application ciblée.

Le générateur de retard selon l'invention peut être utilisé dans le cadre de nombreuses applications. En particulier, il peut être mis en oeuvre dans tous système de production délais de longue durée. Il peut être par exemple utilisé comme minuterie programmable. Dans un tout autre domaine, le générateur de délai peut être utilisé afin de programmer des modèles de pics de neurones.

La figure 6 donne un exemple de système de programmation d'une séquence d'impulsions similaires à celles qui sont émises par des neurones. Des neurones impulsionnels classiques peuvent par exemple être utilisés. Les signaux des neurones impulsionnels peuvent être simulés ou générés par une puce CMOS 20 utilisant des circuits VLSI.

Dans cet exemple, la convention choisie est que le signal s peut prendre un premier et un deuxième état correspondant respectivement aux valeurs 0 et 1.

La sortie *Sn* du circuit de neurone 20 est combinée 21 avec la sortie s du générateur de retards. Un pic en sortie du circuit de neurone 20 n'apparaît au travers du signal *n* que pour la durée pendant laquelle la sortie s du générateur vaut 1. Il ne comprendra pas de pic lorsque le signal s est à 0. Ainsi, en contrôlant le temps à partir duquel la sortie du circuit de neurone est apparente, le modèle de pic final peut être contrôlé. La mise en oeuvre de cette technique permet de réduire la taille de la puce CMOS 20. En effet, un nombre important de transistors et donc de la surface de la puce 20 est habituellement utilisé pour mettre en oeuvre un circuit de contrôle de délai entre deux pics successifs. Des délais extrêmement longs entre pics consécutifs peuvent apparaître. Ces délais sont difficiles à obtenir avec des générateurs de délais classiques à base de condensateurs.

**Revendications**

1. Générateur de retards **caractérisé en ce qu'**il comprend au moins une résistance programmable $R_{PCM}$ (11) en matériau à changement de phase à base de chalcogénure, ladite résistance $R_{PCM}$ étant initialisée pour générer un retard de manière à ce qu'elle soit égale à une valeur initiale $R_0$ et que le chalcogénure soit en phase amorphe, un comparateur (13, 16, 19) comparant une quantité électrique de référence stable dans le temps avec une quantité électrique variable représentative de la résistance programmable $R_{PCM}$ (11), le comparateur générant un signal s présentant une singularité, ladite singularité apparaissant lorsque la différence entre les deux quantités électriques change de signe.

2. Générateur de retards selon la revendication 1 dans lequel la quantité électrique de référence est représentative d'une résistance de référence $R_{reference}$.

3. Générateur de retards selon l'une des revendications précédentes dans lequel un module de programmation (10) initialise la résistance $R_{PCM}$ par émission d'une impulsion électrique, ladite impulsion étant adaptée pour que la résistance $R_{PCM}$ atteigne la valeur initiale $R_0$.

4. Générateur de retards selon la revendication 3 dans lequel les caractéristiques de l'impulsion électrique pour programmer la résistance $R_{PCM}$ sont déterminées en utilisant une table de correspondance.

**5.** Générateur de retards selon l'une des revendications précédentes dans lequel le signal s peut prendre deux états, la singularité correspondant au passage d'un état à l'autre.

**6.** Générateur de retards selon l'une des revendications précédentes dans lequel le comparateur (16) est un comparateur de courants et dans lequel la quantité électrique variable et la quantité électrique de référence sont des intensités.

**7.** Générateur de retards selon l'une des revendications 1 à 5 précédentes dans lequel le comparateur (19) est un comparateur de tensions et dans lequel la quantité électrique variable et la quantité électrique de référence sont des tensions.

**8.** Générateur de retards selon l'une des revendications précédentes dans lequel la valeur de $R_0$ permettant d'obtenir un retard donné T, est déterminée en utilisant l'expression :

$$R_0 = R_{reference} \times \left( t_0 \Big/ T \right)^\nu$$

dans laquelle :

$R$ est la résistance du matériau PCM à l'instant t ;
$R_0$ est la résistance du matériau PCM à un instant initial $t_0$ ;
$\nu$ est une constante dépendant du type de matériau chalcogénure utilisé.

**9.** Générateur de retards selon l'une des revendications précédentes dans lequel le chalcogénure utilisé est un mélange de germanium, d'antimoine et de tellure.

**10.** Générateur de retards selon la revendication 9 dans lequel le chalcogénure utilisé est du Ge2Sb2Te5.

**11.** Système d'inhibition de neurones artificiels comprenant un circuit de neurones (20), le temps à partir duquel la sortie du circuit de neurones est apparente étant contrôlé (21) par un générateur de retards (22) selon l'une quelconque des revendications précédentes.

**Patentansprüche**

**1.** Verzögerungsgenerator, **dadurch gekennzeichnet, dass** er wenigstens einen programmierbaren Widerstand $R_{PCM}$ (11) aus einem Phasenwechselmaterial auf Chalcogenidbasis umfasst, wobei der Widerstand $R_{PCM}$ zum Erzeugen einer solchen Verzögerung initialisiert wird, dass sie gleich einem Anfangswert $R_0$ ist und dass das Chalcogenid in amorpher Phase vorliegt, wobei ein Komparator (13, 16, 19) eine über die Zeit stabile elektrische Referenzgröße mit einer variablen elektrischen Größe vergleicht, die für den programmierbaren Widerstand $R_{PCM}$ (11) repräsentativ ist, wobei der Komparator ein eine Singularität präsentierendes Signal s erzeugt, wobei die Singularität erscheint, wenn sich das Vorzeichen der Differenz zwischen den beiden elektrischen Größen ändert.

**2.** Verzögerungsgenerator nach Anspruch 1, bei dem die elektrische Referenzgröße für einen Referenzwiderstand $R_{reference}$ repräsentativ ist.

**3.** Verzögerungsgenerator nach einem der vorherigen Ansprüche, bei dem ein Programmiermodul (10) den Widerstand $R_{PCM}$ durch Emission eines elektrischen Impulses initialisiert, wobei der Impuls so ausgelegt ist, dass der Widerstand $R_{PCM}$ den Anfangswert $R_0$ erreicht.

**4.** Verzögerungsgenerator nach Anspruch 3, bei dem die Kennwerte des elektrischen Impulses zum Programmieren des Widerstandes $R_{PCM}$ mit Hilfe einer Korrespondenztabelle ermittelt werden.

**5.** Verzögerungsgenerator nach einem der vorherigen Ansprüche, bei dem das Signal s zwei Zustände annehmen kann, wobei die Singularität dem Übergang von einem Zustand in den anderen entspricht.

**6.** Verzögerungsgenerator nach einem der vorherigen Ansprüche, bei dem der Komparator (16) ein Stromkomparator ist und bei dem die variable elektrische Größe und die elektrische Referenzgröße Intensitäten sind.

**7.** Verzögerungsgenerator nach einem der vorherigen Ansprüche 1 bis 5, bei dem der Komparator (19) ein Spannungskomparator ist und bei dem die variable elektrische Größe und die elektrische Referenzgröße Spannungen sind.

**8.** Verzögerungsgenerator nach einem der vorherigen Ansprüche, bei dem der Wert von $R_0$, mit dem die gegebene Verzögerung T erzielt werden kann, mittels des folgenden Ausdrucks ermittelt werden kann:

$$R_0 = R_{reference} \times \left( t_0 \middle/ T \right)^{\nu}$$

wobei:

$R$ der Widerstand des PCM-Materials zum Zeitpunkt t ist;
$R_0$ der Widerstand des PCM-Materials zum Anfangszeitpunkt $t_0$ ist;
$\nu$ eine Konstante ist, die vom verwendeten Chalcogenidmaterialtyp abhängt.

**9.** Verzögerungsgenerator nach einem der vorherigen Ansprüche, bei dem das benutzte Chalcogenid eine Mischung aus Germanium, Antimon und Tellur ist.

**10.** Verzögerungsgenerator nach Anspruch 9, bei dem das benutzte Chalcogenid Ge2Sb2Te5 ist.

**11.** System zum Inhibieren von künstlichen Neuronen, das eine Neuronenschaltung (20) umfasst, wobei die Zeit, ab der der Ausgang der Neuronenschaltung erscheint, von einem Verzögerungsgenerator (22) nach einem der vorherigen Ansprüche gesteuert (21) wird.

**Claims**

**1.** Delay generator, **characterised in that** it comprises at least one programmable resistance $R_{PCM}$ (11) of phase-change material based on chalcogenide, the resistance RPCM being initialised in order to generate a delay in such a manner that it is equal to an initial value $R_0$ and the chalcogenide is in the amorphous phase, a comparator (13, 16, 19) comparing a reference electrical quantity which is stable over time with a variable electrical quantity which is representative of the programmable resistance $R_{PCM}$ (11), the comparator generating a signal s which has a singularity, the singularity appearing when the difference between the two electrical quantities changes sign.

**2.** Delay generator according to claim 1, wherein the reference electrical quantity is representative of a reference resistance $R_{reference}$.

**3.** Delay generator according to any one of the preceding claims, wherein a programming module (10) initialises the resistance $R_{PCM}$ by emitting an electrical pulse, the pulse being adapted so that the resistance $R_{PCM}$ reaches the initial value $R_0$.

**4.** Delay generator according to claim 3, wherein the features of the electrical pulse for programming the resistance $R_{PCM}$ are determined by using a correspondence table.

**5.** Delay generator according to any one of the preceding claims, wherein the signal may have two states, the singularity corresponding to the passage from one state to the other.

**6.** Delay generator according to any one of the preceding claims, wherein the comparator (16) is a current comparator and wherein the variable electrical quantity and the reference electrical quantity are intensities.

**7.** Delay generator according to any one of the preceding claims 1 to 5, wherein the comparator (19) is a voltage comparator and wherein the variable electrical quantity and the reference electrical quantity are voltages.

8. Delay generator according to any one of the preceding claims, wherein the value of $R_0$ which allows a given delay T to be obtained is determined using the expression:

$$R_0 = R_{reference} \times \left( \frac{t_0}{T} \right)^{v}$$

where:

> $R$ is the resistance of the material PCM at the time t;
> $R_0$ is the resistance of the material PCM at an initial time $t_0$;
> v is a constant dependent on the type of chalcogenide material used.

9. Delay generator according to any one of the preceding claims, wherein the chalcogenide used is an admixture of germanium, antimony and tellurium.

10. Delay generator according to claim 9, wherein the chalcogenide used is Ge2Sb2Te5.

11. Artificial neuron inhibition system comprising a neuron circuit (20), the time from which it is apparent that the neuron circuit is left being controlled (21) by a delay generator (22) according to any one of the preceding claims.

FIG.1

FIG.2

FIG.3

FIG.4

+V

R₁  R₂

27

COMPARATEUR
DE
TENSIONS

19

s

26

R₃  R_PCM

MODULE DE
PROGRAMMATION

10

11

18

FIG.5

MODULE DE
PROGRAMMATION

10

CIRCUIT DE
NEURONE

20

S_n

21

n

s

R_PCM

11

15

COMPARATEUR

13

R_référence

12

14

22

FIG.6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- JP 63312715 A

**Littérature non-brevet citée dans la description**

- **W. F. DAVIS ; T. M. FREDERIKSEN.** a precision monolithic time-delay generator for use in automotive electronic fuel injection systems. *IEEE journal on solid state circuits,* Décembre 1972, vol. 7 (6